# FASCICULE DE BREVET EUROPEEN

(11) **EP 0 511 065 B1**
(45) Date de publication et mention de la délivrance du brevet: **08.10.1997**
(21) Numéro de dépôt: 92401096.0
(22) Date de dépôt: 17.04.1992
(51) Int. Cl.: G06F 3/033, G06F 17/50

(54) **Procédé de décompilation pour la réalisation de graphes au moyen d'un ordinateur**
Verfahren zum Dekompilieren zur Realisierung eines Graphs unter Anwendung eines Rechners
Decompilation method for realising a graph using a computer

(30) Priorité: 22.04.1991 FR 9104922
(43) Date de publication de la demande: 28.10.1992
(73) Titulaire: FRANCE TELECOM, 75015 Paris (FR)
(72) Inventeur: Camacho, Jean, F-75014 Paris (FR); Rouger, Anne, F-92130 Issy les Moulineaux (FR)
(74) Mandataire: Dubois-Chabert, Guy

(56) Documents cités:
- IEEE SOFTWARE. vol. 17, no. 4, Juillet 1990, LOS ALAMITOS US pages 21 - 28; S. MOEN: 'Drawing Dynamic Trees'
- SDL'87: STATE OF THE ART AND FUTURE TRENDS 3 Avril 1987, ELSEVIER, AMSTERDAM, NETHERLANDS pages 117 - 126; JIN. P. HONG ET AL.: 'SDL-Oriented Graphical Environment'

## Description

La présente description concerne un procédé de décompilation pour la réalisation de graphes au moyen d'un ordinateur notamment pour la représentation d'un graphe orienté structuré.

On utilise dans de nombreux domaines des langages dits "orientés". Ces langages sont des langages développés pour une application particulière. C'est le cas par exemple du langage de description et de spécification LDS, défini et normalisé par le CCITT. Ce langage est couramment employé dans le domaine des télécommunications et son utilisation tend à s'élargir à tout type d'application temps réel.

Dans de tels langages et tout particulièrement dans le langage LDS, on utilise des graphes orientés structurés. Un graphe structuré est un diagramme composé d'éléments en relation.

Lorsque des modifications du diagramme doivent être introduites, on fait appel à des procédés mis en oeuvre par l'ordinateur à partir duquel sont réalisés les graphes pour réorganiser le diagramme. Ces procédés sont des procédés d'édition structurelle qui connaissent la syntaxe de la représentation gardée en mémoire sous forme de représentation interne arborescente dont les sommets sont des structures taxiques.

Le procédé de décompilation mis en oeuvre par le décompilateur effectue la correspondance entre l'arbre de la représentation interne et la représentation graphique du diagramme à l'écran.

L'inconvénient des décompilateurs actuels est qu'ils effectuent le redessin complet du diagramme après chaque modification.

Une première conséquence est la gêne visuelle occasionnée. En effet, les procédés classiques consistent à effacer tout le dessin et à le faire réapparaître à l'écran avec la correction. Or cette opération provoque un effet "flash" qui dérange visuellement et qui ne se produirait pas si le diagramme était réalisé à la main (où dans ce cas, seule la partie utile serait redessinée).

Une seconde conséquence vient du fait que le temps du redessin augmente bien sûr avec la taille du diagramme. Cette conséquence interdit pratiquement l'édition de grands diagrammes et est très pénalisante du point de vue des performances.

La présente invention a pour but de remédier à ces inconvénients. L'invention, telle qu'elle est caractérisée dans les revendications, résout le problème consistant à proposer un procédé de décompilation qui est incrémental et qui permet la réalisation de graphes au moyen d'un ordinateur entraînant un minimum du redessin tout comme pourrait le faire un opérateur avec une gomme et un crayon.

Le procédé conforme à l'invention présente de ce fait le confort visuel recherché et une amélioration considérable du temps de réponse.

La présente invention a plus particulièrement pour objet un procédé de décompilation pour la réalisation de graphes au moyen d'un ordinateur, caractérisé en ce qu'il consiste à définir et enregistrer en mémoire des éléments utilisés pour la construction des graphes sous forme arborescente constitués de noeuds et de branches.

L'invention consiste en un procédé de décompilation pour la réalisation de graphes au moyen d'un ordinateur relié à un écran de visualisation caractérisé en ce qu'il comporte les étapes suivantes :
- définir et enregistrer en mémoire une structure de donnée décrivant tout graphe à toutes les étapes de sa création sous la forme d'une structure arborescente comportant un noeud divergent correspondant à la racine de l'arbre relié à des noeuds simples convergents ou terminateurs, les autres que les noeuds terminateurs étant reliés à d'autres noeuds simples, convergents ou terminateurs, de sorte que les différents noeuds sont la base de structures s'imbriquant les unes dans les autres ;
- établir une table de correspondance entre la représentation interne arborescente décrite dans la structure de donnée et sa représentation graphique externe sur l'écran dans laquelle chaque élément du graphe est repéré par rapport à des zones de l'écran résultant d'un découpage matriciel en lignes et colonnes ;
- procéder à la réalisation effective du graphe en effectuant des opérations d'insertion et/ou de destruction successives d'éléments définis dans la structure de donnée, ces insertions et/ou destructions se faisant dans les zones désirées de l'écran par des opérations successives de décalages des éléments de graphe situés au-delà des zones dans lesquelles se trouve l'élément à insérer ou à détruire ;
- afficher le graphe au fur et à mesure de sa construction et de ses modifications ;
- mettre à jour la description interne et la table de correspondance.

D'autres caractéristiques et avantages de l'invention apparaîtront à la lecture de la description faite à titre illustratif et nullement limitatif en référence aux dessins annexés sur lesquels :
- la figure 1 représente le diagramme arborescent d'un graphe orienté structuré,
- la figure 2 représente le diagramme de ce graphe à l'écran,
- les figures 3, 4 et 5 les diagrammes d'un graphe dans le cas d'une destruction de branche ;
- les figures 6, 7 et 8 les diagrammes d'un graphe dans le cas d'une destruction d'un noeud ;
- les figures 9, 10 et 11 les diagrammes d'un graphe dans le cas de l'insertion d'une branche ;
- les figures 12, 13 et 14 les diagrammes d'un graphe dans le cas de l'insertion d'un noeud.

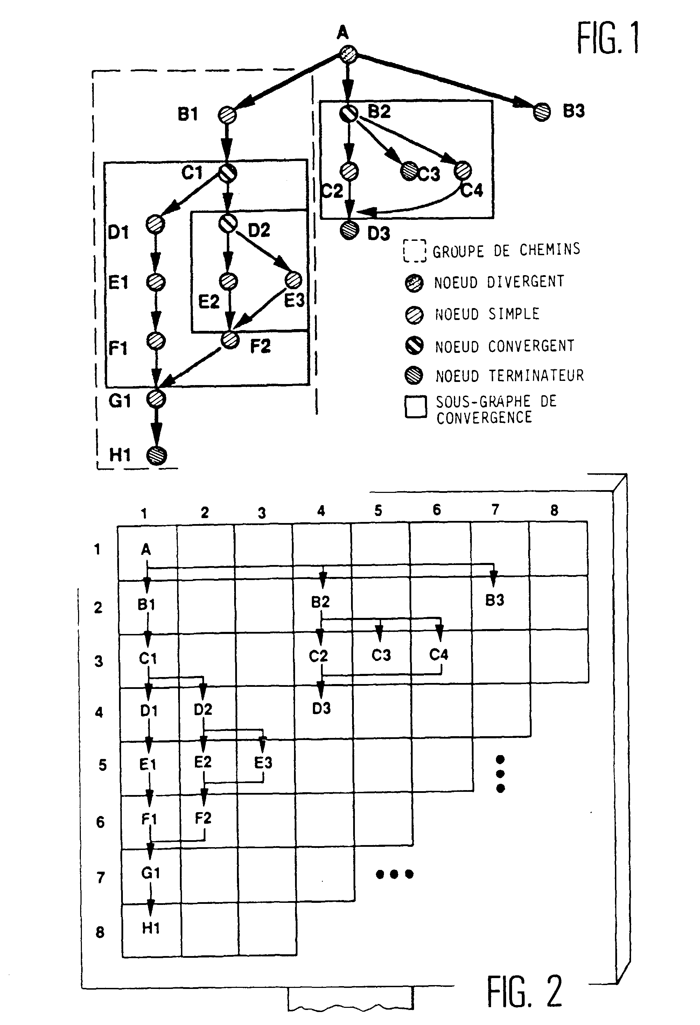

On définit tout d'abord ce que l'on entend par graphe orienté structuré. On peut se reporter au schéma de la figure 1. Il s'agit d'un graphe composé de quatre types de noeuds nommés noeud simple, noeud terminateur, noeud convergent et noeud divergent.

Un noeud simple est un noeud ayant un unique arc sortant, ce noeud possédant un ou plusieurs arcs entrants (par exemple B1, D1, G1).

Un noeud terminateur est un noeud sans arc sortant, ce noeud possédant un ou plusieurs arcs entrants (par exemple H1, D3, B3).

Un noeud divergent est un noeud n'ayant que des arcs sortants et tel qu'il n'y ait aucun noeud commun entre les groupes de chemins engendrés (par exemple A). Un groupe de chemins est l'ensemble des chemins commençant par un arc sortant d'un noeud divergent. Par exemple, le groupe de chemins commençant par l'arc A→B1 est constitué de trois chemins :
(A, B1, C1, D1, E1, F1, G1, H1)
(A, B1, C1, D2, E2, F2, G1, H1)
(A, B1, C1, D2, E3, F2, G1, H1)

Dans la suite, un groupe de chemins est appelé branche (notation A→B1).

Un noeud convergent est un noeud ayant plusieurs arcs sortants et tel que les chemins engendrés :
- ou bien se terminent par un noeud terminateur,
- ou bien convergent vers un unique noeud commun appelé point de convergence.

Un point de convergence peut être un noeud simple (par exemple G1), un noeud terminateur (par exemple D3) ou un noeud convergent.

Un graphe orienté structuré a les particularités suivantes :
1) Le seul noeud divergent est la racine (A). Il représente le graphe. Sa destruction entraîne la destruction du graphe.
2) Un noeud convergent représente une structure dite sous-graphe de convergence, qui correspond à l'ensemble des chemins engendrés à partir du noeud convergent jusqu'aux prédécesseurs du point de convergence.
   La suppression d'un noeud convergent entraîne la destruction du sous-graphe de convergence. Seul subsiste le point de convergence qui se trouve raccordé aux prédécesseurs du noeud convergent détruit. En outre, les noeuds convergents possèdent la propriété suivante : C1 est un noeud convergent et G1 son point de convergence, si, comme c'est le cas sur la figure 1, sur un chemin de C1 vers G1, on a un noeud convergent D2 alors son point de convergence F2 se trouve avant G1 sur le chemin.
   Les groupes de chemins sortant du noeud convergent sont également appelés branche (par exemple branche C1→D1, et branche C1→D2).
3) Tous les chemins engendrés à partir de la racine finissent, soit par un noeud terminateur, soit par un noeud convergent sans point de convergence (dans ce cas, tous les chemins engendrés à partir du noeud convergent finissent par un terminateur).
4) Chaque arc sortant du noeud divergent ou d'un noeud convergent, constitue une structure appelée branche qui représente le groupe de chemins engendré. La suppression d'un tel arc engendre la destruction de tous les chemins.

Les différents noeuds introduits sont la base de structures qui s'imbriquent les unes dans les autres. On distingue les structures mères, les structures filles et les structures soeurs.

Une structure mère est une structure englobant une autre structure.

Une structure fille est une structure englobée par une autre structure.

Des structures soeurs sont des structures de même niveau.

Par exemple, une branche sortant du noeud divergent est :
* une structure fille du noeud divergent
* la structure mère des noeuds appartenant au groupe de chemins engendrés.

Deux branches sortant d'un noeud convergent sont des structures soeurs.

**Sur la figure 1,**
- A est le noeud divergent. Il constitue une structure mère,
- B1, D1, E1, F1, G1, C2, C4, E2, E3, F2 sont des noeuds simples, parmi lesquels G1 et F2 sont des points de convergence,
- H1, D3, B3, C3 sont des noeuds terminateurs parmi lesquels D3 est un point de convergence,
- C1, D2, B2 sont des noeuds convergents engendrant trois sous-graphes de convergence :(C1, D1, E1, F1, D2, E2, E3, F2), (D2, E2, E3), (B2, C2, C3, C4).
- Les branches A→B1, A→B2, A→B3 sont des structures soeurs.
- Les branches C1→D1, C1→D2 sont des structures soeurs.

**La figure 2** correspond à la représentation graphique à l'écran du graphe de la figure 1 conformément à l'invention.

Le graphe orienté structuré est représenté sous forme matricielle correspondant à un pavage de l'écran. Le pavage est obtenu par découpage de l'écran en zones rectangulaires régulières.

Les noeuds du graphe sont centrés dans un rectangle de base : les arcs sont représentés verticalement, horizontalement ou les deux à la fois.

On définit dans la suite quelques termes utilisés pour la construction d'un graphe orienté structuré. Cette construction met en oeuvre deux types de "composition graphique" à savoir : les arrangements horizontaux et les arrangements verticaux.

### Les arrangements :

Les arrangements horizontaux correspondent aux branches sortant du noeud divergent ou d'un noeud convergent (rectangles placés côte à côte).

Les arrangements verticaux correspondent aux noeuds figurant sur une branche (rectangles placés les uns en-dessous des autres).

### La taille des noeuds et des branches :

Un noeud est représenté dans une zone rectangulaire composée de pavés de base. Cette zone est définie par ses coordonnées dites ligne et colonne, par sa largeur dite x-noeud et sa hauteur dite y-noeud. Un noeud simple ou un noeud terminateur a toujours pour dimension x-noeud=1 et y-noeud=1.

Le noeud divergent a pour dimension la taille du graphe.

Dans l'exemple de la figure 2, ligne (A)=1, colonne (A)=1, x-noeud (A)=7 et y-noeud(A)=8.

Un noeud convergent a pour dimension la taille du sous-graphe de convergence. Dans notre exemple, ligne (C1)=3, colonne (C1)=1, x-noeud(C1)=3 et y-noeud(C1)=4.

Une branche est également représentée dans une zone rectangulaire composée de pavés de base. Cette zone est définie par ses coordonnées dites ligne et colonne, par sa largeur dite x-branche et sa hauteur dite y-branche. Dans notre exemple, ligne (A→B2)=1, colonne (A→B2)=4, x-branche(A→B2)=3 et y-branche (A→B2)=3.

### Les Arcs :

La représentation graphique définie précédemment engendre quatre formes d'arcs.

On appelle flèche horizontale un arc sortant du noeud divergent ou d'un noeud convergent. Ces arcs sont caractérisés par :
Leurs coordonnées :
colonne d'arrivée, "colonne"
ligne d'arrivée, "ligne"
Leur longueur, "x-taille"

Dans l'exemple précédent, la flèche horizontale A→B1 a pour coordonnées colonne=1 ; ligne=2 ; et pour longueur x-taille=0. La flèche horizontale D2→E3 a pour coordonnées colonne=3 ; ligne=5 ; et pour longueur x-taille=1. La flèche horizontale A→B3 a pour coordonnées colonne=7, ligne=2 et x-taille=3.

On appelle flèche normale la représentation graphique d'un arc sortant d'un noeud simple et entrant sur un noeud simple ou un noeud terminateur autre qu'un point de convergence. Ces arcs sont caractérisés par :
Leurs coordonnées :
colonne d'arrivée, "colonne"
ligne d'arrivée, "ligne"

Par exemple, la flèche normale E1→F1 a pour coordonnées colonne=1 ; ligne=6.

La représentation graphique des arcs entrant sur un point de convergence est morcelée selon les chemins aboutissant au point de convergence. Ainsi, sur l'exemple précédent, l'arc allant de E3 vers F2 ne sera représenté graphiquement que par le trait vertical-horizontal allant de E3 jusqu'à la flèche E2→F2 puisque la flèche figure déjà dans l'arc E2→F2 On est donc amené à définir deux notions :
- la notion de petite flèche qui représente la flèche entrant sur un point de convergence et
- la notion de lien qui est un trait représentant une portion d'arc. Un lien est associé à un chemin.
- Exemple :

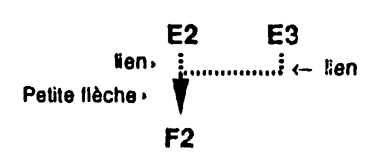

Une petite flèche est caractérisée par :
ses coordonnées :
colonne d'arrivée, "colonne"
ligne d'arrivée, "ligne"

Un lien est caractérisé par :
ses coordonnées :
colonne de départ, "colonne"
ligne de départ, "ligne"
son étendue :
sa hauteur, "y-taille"
sa largeur, "x-taille"

On distingue deux types de liens : les liens horizontaux et les liens verticaux-horizontaux.

Un lien vertical-horizontal est associé aux chemins qui ne finissent pas par un noeud terminateur.

Dans l'exemple précédent, l'arc C2→D3 est composé d'un lien vertical-horizontal et d'une petite flèche. La petite flèche a pour coordonnées : colonne=4 ; ligne=4. Le lien a pour coordonnées : colonne=4 ; ligne=3 ; et pour étendue x-taille=0 ; et y-taille=0. Les caractéristiques du lien associé à C4 sont : colonne=6 ; ligne=3 ; x-taille=1 ; et y-taille=0.

Un lien horizontal est associé à un chemin qui vérifie les trois conditions suivantes :
- ce chemin n'est pas le premier,
- ce chemin se finit par un terminateur,
- il existe un chemin à droite qui ne se finit pas par un terminateur.

Dans l'exemple précédent, le lien horizontal C3→D3 a pour coordonnées: colonne=5 ; ligne=3 ; et pour étendue x-taille=1 ; et y-taille=0.

Pour chaque noeud convergent, on remarque les points suivants :

Si tous les chemins finissent par un noeud terminateur, il n'y a pas de petite flèche.

Dans le cas contraire, il y a une, et seulement une, petite flèche, construite dès qu'un chemin ne se finit pas par un terminateur.

Conformément à l'invention, le procédé permet de minimiser le redessin en cas de modification. Le procédé décrit ci-après permet de calculer les parties du graphe touchées par une modification, c'est-à-dire conformément à l'invention les parties à déplacer ;

Comme cela sera détaillé dans la suite, le procédé permet, malgré la complexité des imbrications de structures et notamment des sous-graphes de convergence de ne modifier le graphe que localement.

On distingue deux types de modifications :
- la destruction et
- l'insertion.

Toute modification a des répercussions sur la structure englobante, 'c'est-à-dire celle qui contient l'élément à détruire ou celle qui contient l'élément référence par rapport auquel on fait l'insertion. Ces modifications peuvent se répercuter au niveau supérieur. Le procédé de décompilation incrémentale réalise les modifications de proche en proche, c'est-à-dire de structure englobante en structure englobante, jusqu'à la non évolution de certains paramètres (détaillés dans la suite) et au plus jusqu'au noeud divergent.

Le procédé de décompilation va maintenant être décrit dans ses étapes principales puis de façon détaillée à partir d'exemples donnés.

Ce procédé est susceptible d'être mis en oeuvre par tout type d'ordinateur avec lequel on cherche à réaliser et à modifier un graphe orienté structuré utilisé notamment par le langage de description et de spécification LDS.

Le procédé consiste à définir une structure de donnée qui décrit tout graphe d'état sous la forme d'une structure arborescente (fig. 1).

Cette structure est enregistrée en mémoire dans l'ordinateur ou microordinateur (non représenté). Il s'agit de la représentation interne du graphe. Le procédé consiste ensuite à établir une correspondance entre cette structure arborescente et une représentation externe. Cette représentation exerne est l'image de l'arbre obtenue à l'écran du microordinateur.

Une table de correspondance biunivoque est donc enregistrée. Dans le cas du langage LDS, cette table contient les différents noeuds (start., stop, state, task , decision) correspondant aux noeuds de l'arbre, les liens entre eux et leur emplacement défini par rapport à un découpage matriciel de l'écran.

Chaque état LDS (noeud divergent de l'arbre) est centré dans un pavé de l'écran. Le pavage résulte d'un découpage en zones régulières (zones rectangulaires par exemple).

Les arcs sont représentés verticalement et/ou horizontalement et appartiennent à une ligne ou à une colonne de l'écran.

La table de correspondance comporte également l'identification complète des éléments. Cette identification se fait par une description sur la nature de l'élément, la colonne, la ligne, les tailles horizontale et verticale, le type et la taille des flèches, le lien s'il s'agit d'une branche de décision (noeud convergent). Un lien est décrit par ses coordonnées (ligne et colonne de départ) ainsi que par son étendue dans le sens vertical et horizontal (largeur et hauteur).

La réalisation effective d'un graphe est obtenue par des opération d'insertion et/ou de destruction successives des éléments choisis par l'utilisateur.

Ces opérations d'insertion ou de destruction sont effectuées en réalisant des décalages de position pour les éléments existants qui sont situés au-delà de l'élément à détruire ou à insérer.

### I - OPERATION DE DESTRUCTION

Pour réaliser cette opération, l'opérateur dispose d'un périphérique d'entrée/sortie, par exemple "une souris" et réalise par pointage sur l'écran le choix de l'opération (destruction) et l'élément à détruire.

Le procédé se déroule alors de la manière suivante :
- détermination de la structure englobante de l'élément à détruire ;
- détermination des décalages à effectuer de la droite vers la gauche et de bas en haut ;
- mise à jour de la structure interne.

La détermination de la structure englobante consiste à déterminer la structure branche qui contient la branche ou le noeud à détruire et sa structure mère.

Les opérations de détermination de la structure englobante et de détermination des décalages sont itératives et s'arrêtent lorsque les déplacements à effectuer sont nuls et au plus tard lorsque l'on est remonté jusqu'à la racine de l'arbre (soit jusqu'au noeud divergent).

La destruction d'un élément du graphe consiste donc à effectuer des étapes de déplacements de la droite vers la gauche (appelés déplacements à gauche ou déplacements horizontaux) et des étapes de déplacements de bas en haut (appelés déplacements en haut ou déplacements verticaux).

### A) Description d'une opération de destruction d'un élément

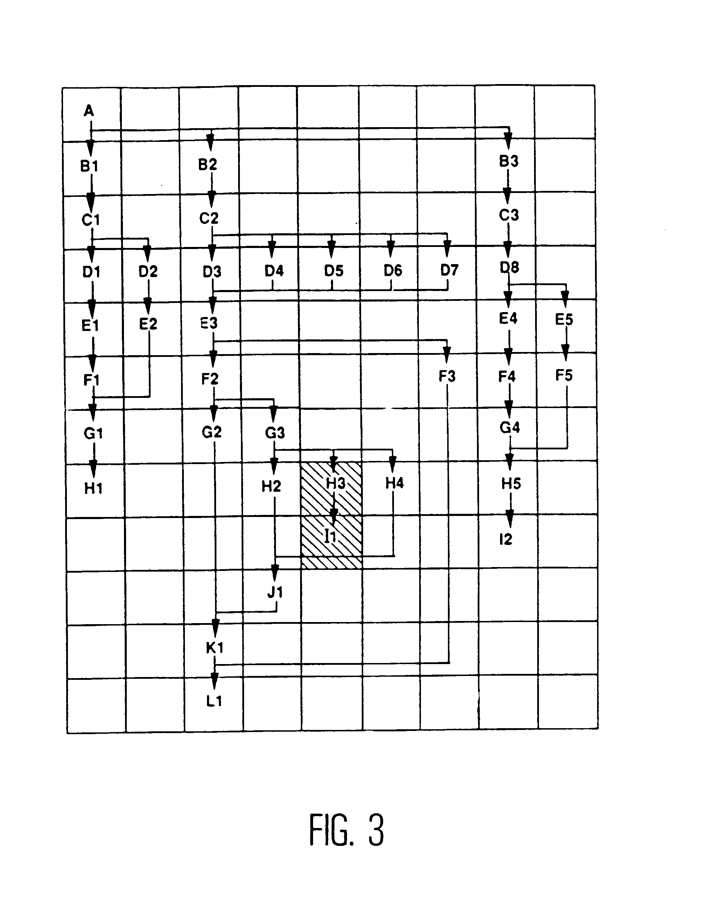

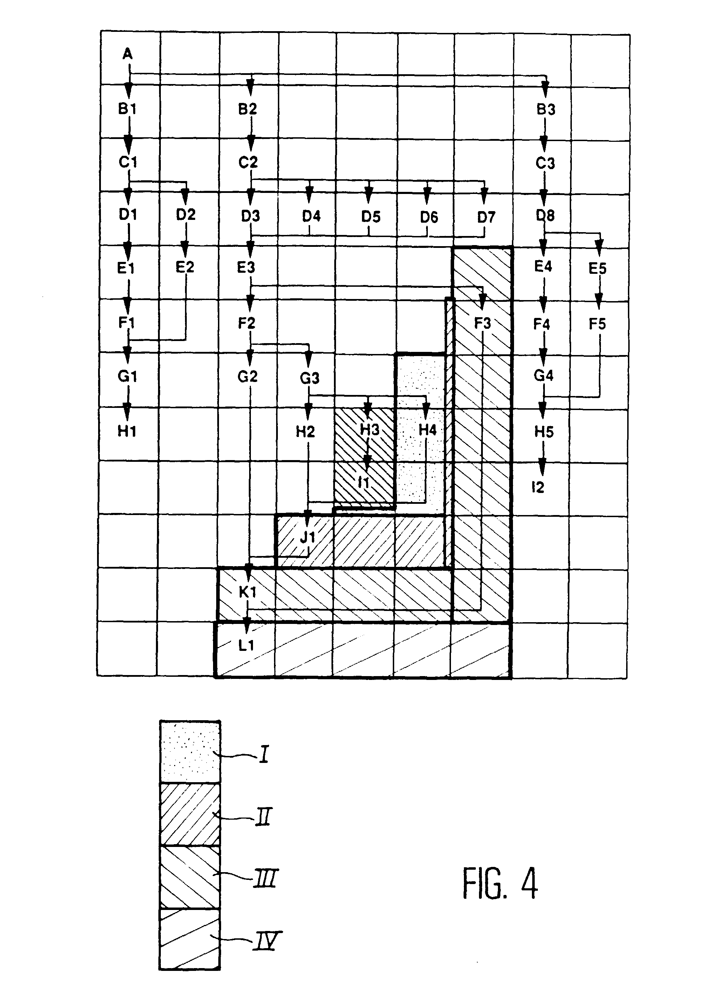

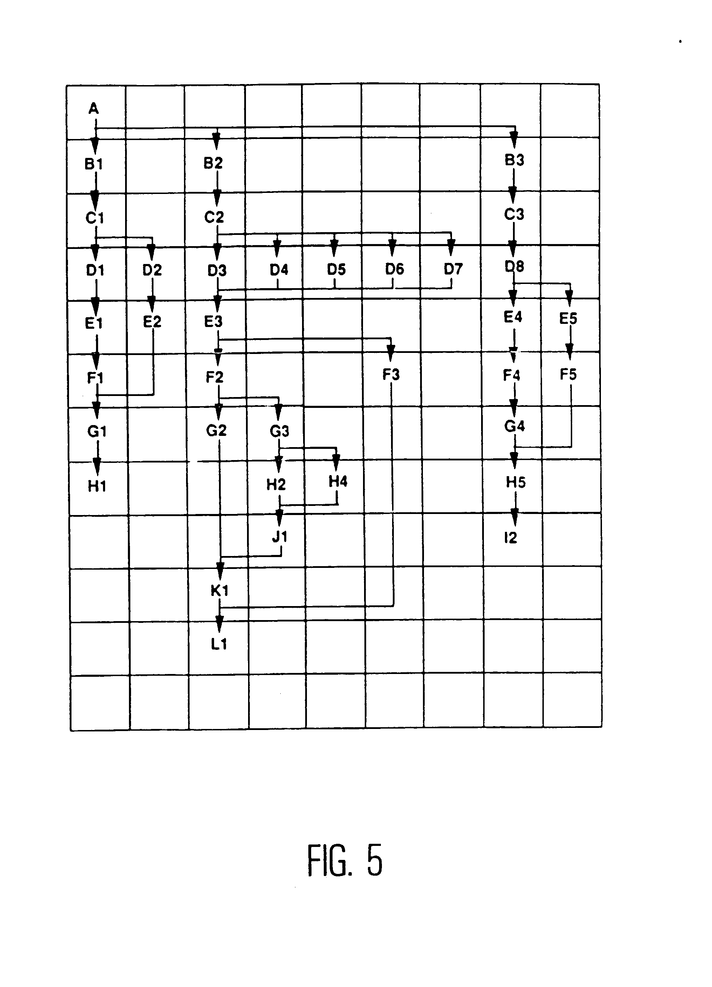

Si l'on considère l'exemple donné à la figure 3, la destruction de la branche G3→H3 va conduire, dans une première étape, au déplacement à gauche de la branche G3→H4. Ces modifications entraînent, dans une deuxième étape, un déplacement en haut du noeud Jl car les deux branches restantes (G3→H2 et G3→H4 ont une longueur inférieure à celle de la branche détruite. Dans une troisième étape, on a un déplacement à gauche de la branche E3→F3, et un déplacement en haut du noeud K1. Enfin, dans une dernière étape, on a un déplacement en haut du noeud L1 et pas de déplacement à gauche de la branche A→B3 (en raison de la largeur du noeud convergent C2). Le résultat final est donné à la figure 5. La figure 4 montre les différentes étapes du calcul qui seront détaillées dans la suite.

A chaque étape on considère les deux structures :
- une structure branche, et
- sa structure mère (noeud convergent ou noeud divergent contenant la branche).

Au départ, la structure branche est :
- celle qui contient le noeud à détruire,
- ou la branche elle-même dans le cas de la destruction d'une branche.

A l'étape suivante, la structure branche est la branche sur laquelle se trouve la structure mère de l'étape précédente qui devient la structure fille. L'arrêt des modifications se produit lorsque les déplacements horizontaux et verticaux sont nuls, ou lorsque la structure mère est le noeud divergent.

Dans l'exemple de la figure 3, on a quatre étapes qui sont les suivantes :

### 1ère étape :

La structure branche est la branche G3 →H3 et la structure mère est le noeud convergent G3.

### 2ème étape :

La structure branche est la branche F2→G3 et la structure mère est le noeud convergent F2.

### 3ème étape :

La structure branche est la branche E3→F2 et la structère mère est le noeud convergent E3.

### 4ème étape :

La structure branche est la branche A→B2 et la structure mère est le noeud divergent A.

A chaque étape, les modifications sont faites en fonction des modifications à l'étape précédente. Pour chaque étape, on calcule la valeur des déplacements à effectuer (déplacement horizontal et déplacement vertical) et la valeur de deux régions rectangulaires à déplacer (une région à droite et une région en bas). Le déplacement horizontal agit sur la région à droite. Le déplacement vertical agit sur la région en bas.

Les régions à droite et en bas sont définies par leurs coordonnées (colonne et ligne du pavé en haut et à gauche de la région), leur hauteur et leur largeur.

Lorsque le déplacement horizontal est nul, la région à droite n'est pas calculée. Lorsque le déplacement vertical est nul, la région en bas n'est pas calculée.

Le déplacement horizontal est nommé x-depl. Le déplacement vertical est nommé y-depl.

La valeur des déplacements initiaux et de la région en bas initiale dépend du type de destruction :
1. Dans le cas de la destruction d'une branche :
   . x-depl-initial=- x-branche (structure branche)
   . y-depl-initial=- y-branche(structure branche)
   . Région en bas initiale :
      ligne=ligne(structure branche)+y-branche (structure branche)
      colonne=colonne (structure branche)
      largeur=x-branche (structure branche)
      hauteur=y-noeud (structure mère)- y-branche (structure branche)-1.
2. Dans le cas de la destruction d'un noeud :
   . x-depl-initial=Min(0, Max(x-noeud, noeud structure branche et noeud ≠ à détruire)
      - x-branche (structure branche))
   . y-depl-initial=- y-noeud
   . Région en bas initiale :
      ligne=ligne (noeud)+y-noeud (noeud)
      colonne=colonne (structure branche)
      largeur=x-branche (structure branche)
      hauteur=y-noeud (structure mère)- Σ (y-noeud, noeud ε structure branche, et à partir du noeud suivant le noeud modifié)-1.

Pour les étapes suivantes, quel que soit le type de destruction, et de plus, à l'initialisation en ce qui concerne la région à droite, on a :
. y-depl=Min(O,Max(y-branche, branche ε structure mère)
   - y-noeud (structure mère)+1)
. x-depl=Min(0,Max(x-noeud, noeud ε structure branche)
   - x-branche (structure branche)
. Région à droite :
   ligne=ligne (structure mère)
   colonne=colonne (structure branche)+x-branche (structure branche)
   largeur=si il existe une branche à droite de la structure branche
      alors colonne (structure mère)+x-noeud (structure mère)-colonne (branche à droite). sinon 0
   hauteur=y-noeud (structure mère)
. Région en bas :
   ligne=ligne(structure fille)+y-noeud(structure fille)- y-depl
   colonne=colonne(structure branche)
   largeur=x-branche(structure branche)
   hauteur= (y-noeud, noeud (structure branche et noeud suivant la structure fille)

Le traitement des flèches consiste à modifier :
. la coordonnée-colonne de toutes les branches à droite de la structure branche, s'il en existe :
   pour toute branche à droite bi
   colonne (bi)=colonne (bi)+x-depl
. la x-taille de la flèche horizontale de la branche immédiatement à droite de la structure branche.

En cas de destruction d'une branche, et uniquement à la première étape
x-taille (branche-à-droite)=x-taille (structure branche).

Dans tous les autres cas :
x-taille (branche-à-droite)=
x-taille (branche-à-droite)+x-depl

Le traitement de liens : Ce cas concerne les noeuds convergents. L'analyse du noeud se fait à travers toutes ses branches (bi) et de droite à gauche (bi, i=l à n, l représentant la branche la plus à droite). Les liens sont calculés à chaque étape.

Trois cas différents peuvent se présenter :

La branche bi n'a pas de lien :

Le dernier noeud de la branche bi est un terminateur et il n'y a pas de liens à droite (toutes les branches à droite de bi finissent par un noeud terminateur).

Dans ce cas, aucune information n'est calculée.

La branche bi a un lien horizontal :

Le dernier noeud de la branche bi est un terminateur et il y a au moins un lien à droite (au moins une des branches à droite de bi ne se finit pas par un terminateur).

Dans ce cas, il faut calculer les coordonnées de départ du lien et son étendue.y-taille(bi) dans un lien horizontal est toujours=0.
colonne=colonne(bi)
ligne=ligne(structure mère)+y-noeud(structure mère)-1
x-taille = x-branche(branche à gauche(bi+1))
s'il y a une branche à gauche sinon 0
y-taille=0

La branche bi a un lien vertical-horizontal :

Le dernier noeud de la branche bi n'est pas un terminateur. Dans ce cas, il faut calculer les coordonnées de départ du lien et son étendue.
colonne=colonne(bi)
ligne=ligne(bi)+y-branche(bi)
x-taille = x-branche (branche à gauche (bi+1)) s'il y a une branche à gauche sinon 0
y-taille=y-noeud(structure mère)-y-branche(bi)-1

### B/ Description plus détaillée des différentes étapes du procédé dans le cas d'une opération de destruction.

### 1/ Le procédé comporte tout d'abord une étape d'initialisation consistant à :

a) déterminer la structure branche initiale et sa structure mère,
b) calculer les déplacements initiaux : déplacement horizontal (x-depl) et déplacement vertical (y-depl)
c) calculer la région à droite initiale et la région en bas initiale.

### 2/ Puis, le procédé met en oeuvre les étapes itératives suivantes :

a) traitement des flèches
b) mise à jour de la structure branche
   x-branche(structure branche)=x-branche(structure branche) + x -depl
   y-branche(structure branche)=y-branche(structure branche)+ y-depl
c) déplacement horizontal de la région à droite
d) déplacement vertical de la région en bas
e) calcul du nouveau déplacement vertical
   y-depl=Min(0,Max (y-branche, branche ε structure mère)-y-noeud (structure mère)+1)
f) mise à jour de la structure mère
   x-noeud(structure mère)=x-noeud(structure mère) + x-depl
   y-noeud(structure mère)=y-noeud(structure mère) + y-depl
g) traitement des liens
h) Si la structure mère est le noeud divergent ou
   si les déplacements sont tous les deux nuls
   alors arrêt
   sinon
      . calcul de la nouvelle structure branche
      . calcul de la structure fille
      . calcul de la nouvelle structure mère
      . calcul du nouveau déplacement horizontal x-depl=Min(0, Max(x-noeud, noeud appartenant à la structure branche)-x-branche (structure branche))
      . calcul de la nouvelle région à droite
      . calcul de la nouvelle région en bas
      . retour en 2a).

Deux exemples sont donnés dans la suite pour illustrer ce procédé, il s'agit d'un exemple concernant la destruction d'une branche et l'autre la destruction d'un noeud.

### a) Destruction d'une branche (figures 3, 4, 5).

La figure 4 montre graphiquement les différents pas du procédé lors de la mise à jour du diagramme. Les régions I sont déplacées lors de la première étape, les régions II lors de la deuxième étape, les régions III lors de la troisième étape et les régions IV lors de la quatrième étape.

### Initialisation :

. Structure branche=branche G3→H3
. Structure mère : noeud convergent G3.
. x-depl=-x-branche(G3→H3)=-1
. y-depl=-y-branche(G3→H3)=-2
. Région à droite initiale
   ligne=ligne (G3)=7
   colonne=colonne (G3→H3) + x-branche (G3→H3)=5+1=6
   largeur=colonne (G3) + x-noeud (G3)-colonne (G3→H4)=4+3-6=1
   hauteur=y-noeud (G3)=3
. Région en bas initiale
   ligne=ligne (G3→H3) + y-branche(G3→H3) =7+2=9
   colonne=colonne (G3→H3)=5
   largeur=x-branche(G3→H3)=1
   hauteur=y-noeud (G3)-y-branche (G3→H3)-1 =3-2-1=0

### Etape 1 (région I, figure 4)

. Traitement de la flèche (branche G3→H4)
   colonne (G3→H4)=6-1=5
   x-taille(G3→H4)=x-taille (G3→H3)=1
   (destruction d'une branche, 1ère étape)
. Mise à jour de la structure branche
   x-branche(G3→H3)=1-1=0
   y-branche (G3→H3)=2-2=0
. Déplacement horizontal de la région à droite
. Déplacement vertical de la région en bas
. Calcul du déplacement vertical pour modification de la structure mère
   y-depl= Min(0, max(1,0,1)-3+1)=-1
. Taille finale de la structure mère
   x-noeud(G3)=3-1=2
   y-noeud(G3)=3-1=2
. Traitement des liens. Le déplacement vers la gauche a été réalisé.
branche (G3→H4).(b1). Lien vertical horizontal
colonne=colonne(b1)=5
ligne=ligne(b1)+y-branche(b1)=7+1=8 x-taille=x-branche(G3→H2)=1
y-taille=y-noeud(G3)-y(branche (b1)-1=2-1-1=0
branche (G3→H2).(b2). Lien vertical horizontal
colonne=colonne(b2)=4
ligne=ligne(b2)+y-branche(b2)=7+1=8
x-taille=0 (pas de branche à gauche)
y-taille=y-noeud(G3)-y-branche (b2)-1=2-1-1=0

. Nouvelle structure branche : branche F2→G3
. Nouvelle structure fille : noeud convergent G3
. Nouvelle structure mère : noeud convergent F2
. x-depl=Min(0, Max (2,1)-3)=-1.
. Région à droite
   ligne=ligne(F2)=6
   colonne=colonne
   (F2→G3)+x-branche(F2→G3)=4+3=7
   largeur=0 ; pas de branche à droite de F2→G3
   hauteur=y-noeud (F2)=5
. Région en bas
   ligne=ligne (G3)+y-noeud (G3)+1=7+2+1=10
   colonne=colonne (F2→G3)=4
   largeur=x-branche (F2→G3)=3
   hauteur=y-noeud (Ji) = 1

### Etape 2 (région II, figure 4):

. Traitement des flèches : Néant : pas de branche à droite de la structure branche
. Mise à jour de la structure branche
   x-branche=3-1=2
   y-branche=4-1=3
. Déplacement horizontal de la région à droite
. Déplacement vertical de la région en bas
. Calcul du nouveau déplacement vertical pour modification de la structure mère
   y-dep1=Min(0, Max(1, 3)-5+1)=-1
. Taille finale de la structure mère
   x-noeud (F2)=4-1=3
   y-noeud (F2)=5-1=4
. Traitement des liens. Le déplacement vers la gauche a été réalisé.
branche (F2→G3).(b1). Lien vertical-horizontal
colonne=colonne (b1)=4
ligne=ligne(b1)+y-branche(b1)=6+3=9
x-taille=x-branche(F2→G2)=1
y-taille=y-noeud(F2)-y-branche(b1)-1=4-3-1=0
branche(F2)→G2). (b2). Lien vertical-horizontal
colonne=colonne(b2)=3
ligne=ligne(b2)+y-branche(b2)=6+1=7
x-taille=0 pas de branche à gauche de b2
y-taille=y-noeud(F2)-y-branche(b2)-1=4-1-1=2

. Nouvelle structure branche : branche E3→F2
. Nouvelle structure fille : noeud convergent F2
. Nouvelle structure mère = Noeud convergent E3
   x-depl= Min(0, Max(3, 1)-4)=-1
. Région à droite
   ligne=ligne (E3)=5
   colonne=colonne (E3→F2)+x-branche(E3→F2) = 3+4=7
   largeur=colonne(E3)+x-noeud (E3)-colonne (E3→F3)=3+5-7=1
   hauteur=y-noeud (E3)=7
. Région en bas
   ligne=ligne (F2)+ y-noeud (F2)-y-depl = 6+4+1=11
   colonne=colonne (E3→F2)=3
   largeur=x-branche(E3→F2)=4
   hauteur=y-noeud (K1)=1

### Etape 3 (région III, figure 4)

. Traitement des flèches
   colonne (E3→F3)=7-1=6
   x-taille(E3→F3)=4-1=3
. Mise à jour de la structure branche
   x-branche=4-1=3
   y-branche=6-1=5
. Déplacement horizontal de la région à droite
. Déplacement vertical de la région en bas
. Nouveau déplacement vertical pour modification de la structure mère
   y-depl=Min(0, Max(5, 1)-7+1)=-1
. Taille finale de la structure mère
   x-noeud(E3)=5-1=4
   y-noeud (E3)=7-1=6
. Traitement des liens. Le déplacement vers la gauche a été réalisé.
branche (E3→F3).(b1). Lien vertical horizontal
colonne=colonne (b1)=6
ligne=ligne (b1)+y-branche (b1)=5+1=6
x-taille=x-branche(E3→F2)=3
y-taille=y-noeud(E3)-y-branche(E3→F3)-1=6-1-1=4
branche (E3→F2).(b2). Lien vertical horizontal
colonne=colonne(b2)=3
ligne=ligne(b2)+y-branche(b2)=5+5=10
x-taille=0 (pas de branche à gauche)
y-taille=y-noeud(E3)-y-branche(E3→F2)-1 =6-5-1=0

. Nouvelle structure branche : branche A→B2
. Nouvelle structure fille : noeud convergent E3
. Nouvelle structure mère : noeud divergent A
   x-depl=Min(0, Max(1, 5, 4, 1)-5=0
. Région à droite
   ne se calcule pas car x-depl=0
. Région en bas
   ligne=ligne (E3)+ y-noeud
   (E3)+y-depl=5+6+1=12
   colonne=colonne (A→B2)=3
   largeur = x-branche(A→B2)=5
   hauteur=y-noeud(L1) = 1

### Etape 4 (région IV, figure 4) :

. Traitement de la flèche : Néant car x-depl=0
. Mise à jour de la structure branche
   x-branche=5+0=5
   y-branche=11-1=10
. Déplacement vertical de la région en bas
. Nouveau déplacement vertical pour modification de la structure mère
   x-noeud (A) = 9+0=9
   y-noeud (A)= 12-1=11
. Traitement des liens
Néant : la structure mère est le noeud divergent
. Arrêt car la structure mère est le noeud divergent.

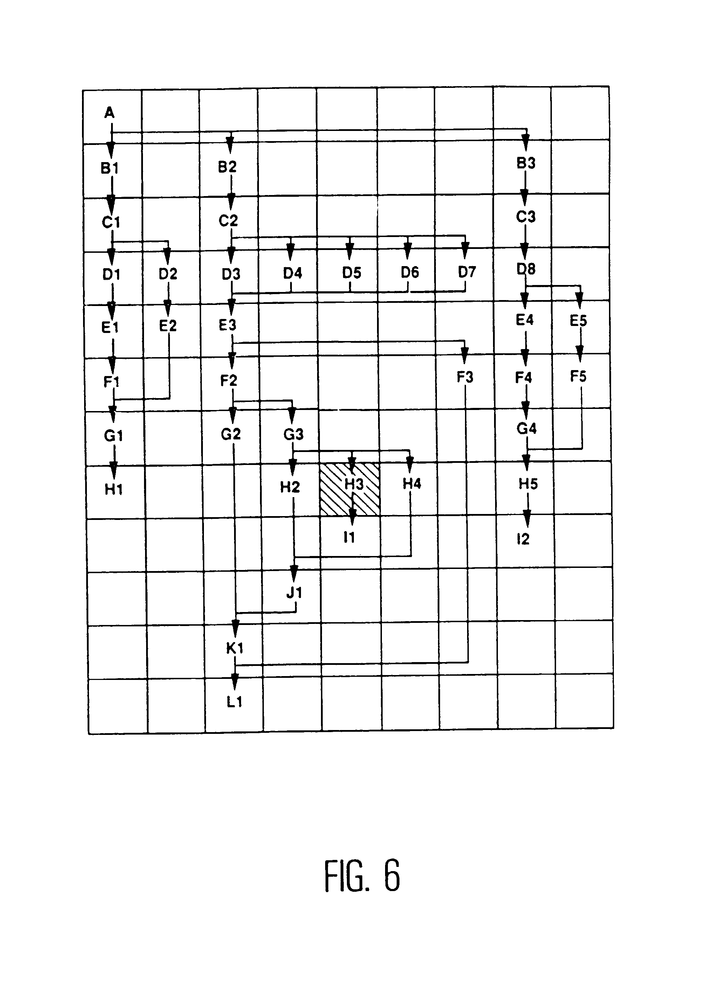

### b) destruction d'un noeud (cf figures 6, 7, 8).

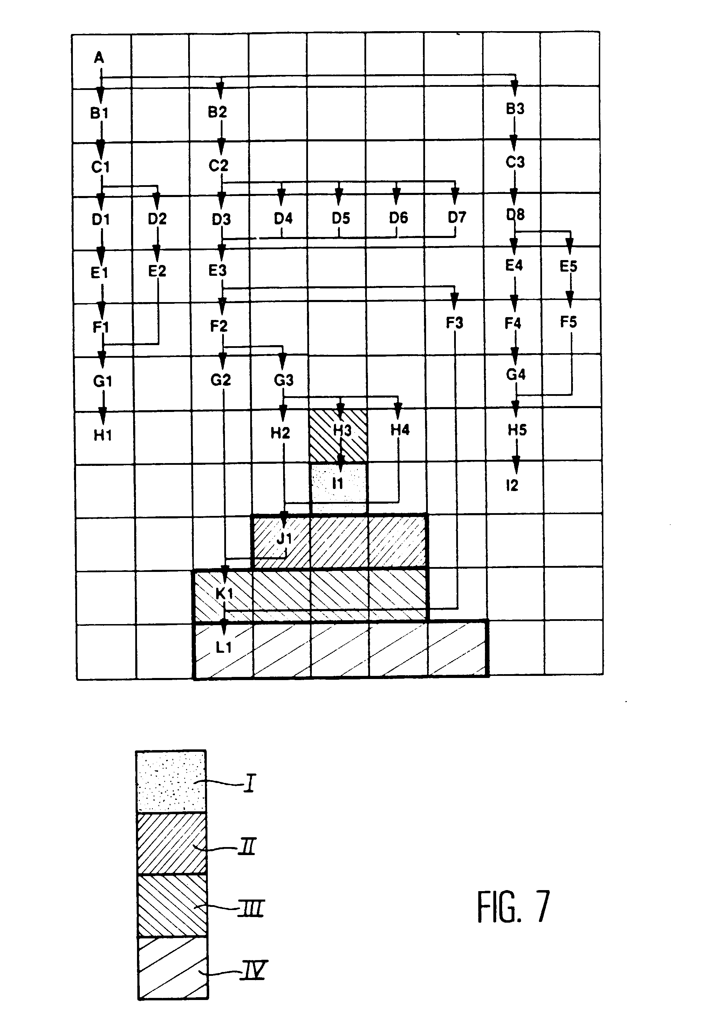

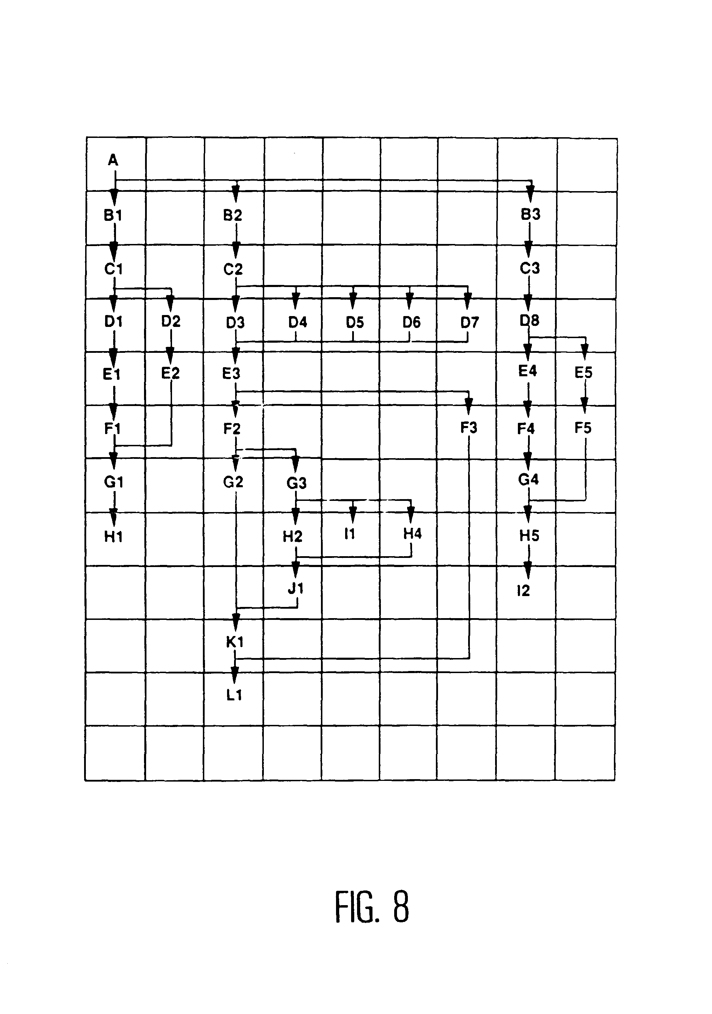

La figure 6 montre le noeud à détruire H3, la figure 7 donne les différents pas pour la mise à jour des diagrammes, la figure 8 donne le résultat obtenu. La région I est déplacée lors de la première étape, la région II lors de la deuxième étape, la région III lors de la troisième étape et la région IV lors de la quatrième étape.

Destruction du noeud H3 (figures 6, 7, 8).

### Initialisation

. structure branche = branche G3→H3
. structure mère = noeud convergent G3
. Déplacements initiaux
   x-depl= Min(0, Max(1-1)=0
   y-depl=-1
. Région à droite
   on ne la calcule pas car x-depl=0
. Région en bas
   ligne=ligne (H3)+ Y-noeud(H3)=8+1=9
   colonne=colonne (G3→H3)=5
   largeur = x-branche (G3→H3)=1
   hauteur = 3-(1)-1=1

### Etape 1 ( région 1, figure 7) :

. Pas de traitement des flèches, car x-depl=0
. Mise à jour de la structure branche
   x-branche=1+0=1
   y-branche=2-1=1
. Déplacement vertical de la région en bas
. Calcul du nouveau déplacement vertical pour modification de la structure mère
   y-depl= Min(0, Max(1, 1, 1)-3+1)=-1
. Taille finale de la structure mère
   x-noeud (G3)=3+0=3
   y-noeud (G3)=3-1=2
. Traitement des liens
branche (G3→H4).(b1). Lien vertical horizontal
colonne=colonne (b1)=6
ligne=ligne(b1)+ y-branche(b1)=7+1=8
x-taille=x-branche(G3→H3)=1
y-taille=y-noeud(G3)-y-branche(b1)-1=2-1-1=0
branche (G3→H3).(b2). Lien horizontal
colonne=colonne(b2)=5
ligne=ligne(G3)+y-noeud(G3)-1=7+2-1=8
x-taille=x-branche (G3→H2)=1
y-taille=0
branche (G3→H2).(b3). Lien vertical-horizontal
colonne=colonne(b3)=4
ligne=ligne(b3)+y-branche(b3)=7+1=8
x-taille=0 (pas de branche à gauche)
y-taille=y-noeud(G3)-y-branche(b3)-1 = 2-1-1=0

. Nouvelle structure branche=branche F2→G3
. Nouvelle structure fille = noeud convergent G3
. Nouvelle structure mère = noeud convergent F2
   x-depl= Min(0, Max(3,1)-3)=0
. Région à droite
   ne se calcule pas, car x-depl=0
. Région en bas :
   ligne=ligne(G3)+y-noeud (G3)-y-depl=7+2 +1=10
   colonne=colonne (F2→G3)=4
   largeur=x-branche (F2→G3)=3
   hauteur=y-noeud(J1)=1

### Etape 2 (région II, figure 7) :

. Traitement des flèches : néant car x-depl=0
. Mise à jour de la structure branche
   x-branche=3+0=3
   y-branche=4-1=3
. Déplacement vertical de la région en bas
. Nouveau déplacement vertical pour mise à jour de la structure mère
   y-depl= Min(0, Max(1, 3)-5+1)=-1
. Taille finale de la structure mère
   x-noeud=4+0=4
   y-noeud=5-1=4
   Traitement des liens
   branche (F2→G3).(b1). Lien vertical-horizontal
   colonne=colonne(b1)=4
   ligne=ligne(b1)+y-branche(b1)=6+3=9
   x-taille=x-branche (F2→G2)=1
   y-taille=y-noeud(F2)-y-branche(b1)-1=4-3-1=0 branche(F2→G2).(b2). Lien vertical-horizontal
   colonne=colonne(b2)=3
   ligne=ligne(b2)+y-branche(b2)=6+1=7
   x-taille=0 (pas de branche à gauche)
   y-taille=y-noeud(F2)-y-branche(b2)-1=4 -1-1=2

   . Nouvelle structure branche=branche E3→F2
      Nouvelle structure fille = noeud convergent F2
   . Nouvelle structure mère = noeud convergent E3
      x-depl= Min (0, Max (4,1)-4)=0
   . Région à droite
      ne se calcule pas car x-depl=0
   . Région en bas
      ligne=ligne (F2)+y-noeud(F2)-y-depl=6+4 +1=11
      colonne=colonne(E3→F2)=3
      largeur=x-branche(E3→F2)=4
      hauteur=y-noeud (K1)=1

### Etape 3 : (région III, figure 7)

. Traitement des flèches : néant car x-depl=0
. Mise à jour de la structure branche
   x-branche=4+0=4
   y-branche=6-1=5
. Déplacement vertical de la région en bas
. Calcul du nouveau déplacement vertical pour mise à jour de la structure mère
   y-depl= Min(0, Max(5,1)-7+1=-1
. Taille finale de la structure mère
   x-noeud (E3)=5+0=5
   y-noeud (E3)=7-1=6
. Traitement des liens
branche (E3→F3).(b1). Lien vertical-horizontal
colonne=colonne(b1)=7
ligne=ligne(b1)+y-branche(b1)=5+1=6
x-taille=x-branche(E3→F2)=4
y-taille=y-noeud (E3)-y-branche(b1)-1 = 6-1-1=4
branche (E3→F2).(b2). Lien vertical-horizontal
colonne=colonne(b2)=3
ligne=ligne(b2)+y-branche (b2)= 5+5=10
x-taille=0 (pas de branche à gauche)
y-taille=y-noeud (E3)+y-branche(b2)-1= 6-5-1=0

. Nouvelle structure branche=branche A→B2
. Nouvelle structure fille = noeud convergent E3
. Nouvelle structure mère = noeud divergent A
   x-depl= Min(0, Max(1, 5, 5, 1)-5)=0
. Région à droite
   ne se calcule pas car x-depl=0
. Région en bas
   ligne=ligne(E3+y-noeud(E3)-y-depl=5+6+1=12
   colonne=colonne (A→B2)=3
   largeur=x-branche(A→B2)=5
   hauteur=y-noeud(L)=1

### Etape 4 (région IV, figure 7)

. Traitement des flèches : Néant car x-depl=0
. Mise à jour de la structure branche
   x-branche=5+0=5
   y-branche=11-1=10
. Déplacement vertical de la région en bas
. Nouveau déplacement vertical
   y-depl= Min(0, Max (7, 10, 8)-12+1)=-1
. Taille finale de la structure mère
   x-noeud (A) = 9+0=9
   y-noeud (A) = 12-1=11
. Traitement des liens
   Néant car la structure mère est le noeud divergent
. Arrêt car structure mère = noeud divergent.

### II - OPERATION D'INSERTION

L'insertion consiste à effectuer étapes par étapes des déplacements de la gauche vers la droite (appelés déplacements à droite ou déplacements horizontaux) et des déplacements de haut en bas (appelés déplacements en bas ou déplacements verticaux).

Dans le cas de la destruction, on a commencé par modifier la structure qui englobe l'élément à détruire, puis on a effectué les modifications et les déplacements de structure englobante en structure englobante, jusqu'à ce que les déplacements deviennent nuls ou au plus jusqu'à la racine.

Pour l'insertion, les déplacements vont en sens contraire. On réalise des déplacements de la structure englobante de plus haut niveau touchée par la modification, jusqu'à la structure qui contiendra l'élément à insérer.

L'opération d'insertion comporte donc deux phases distinctes :

La première phase consiste en un calcul des déplacements et des régions à déplacer et un calcul des modifications des structures branche et des structures mère.

Une fois la structure englobante de plus haut niveau déterminée, la deuxième phase consiste à redescendre dans les structures, à effectuer les déplacements puis à réaliser l'insertion.

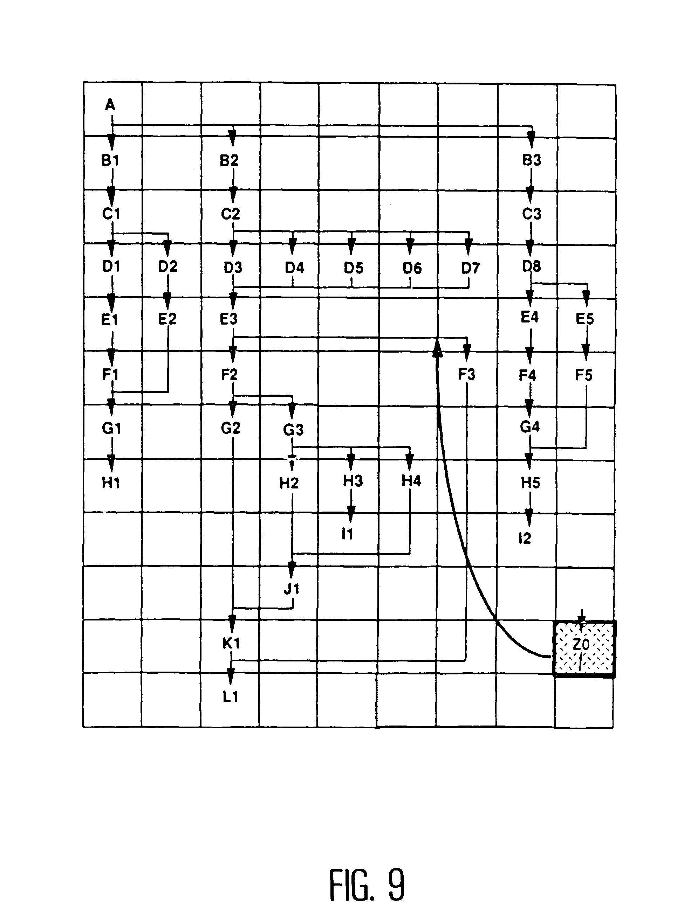

La figure 9 montre un diagramme dans lequel on procède à l'insertion d'une branche E3→Z0.

On détermine, à chaque étape, deux structures :
- une structure branche et
- sa structure mère (noeud convergent ou noeud divergent contenant la branche).

Au départ, la structure branche est :
- celle qui contient le noeud à insérer ou,
- la branche bi vide (x-branche=0, y branche=0) dans le cas de l'insertion d'une branche, positionnée à l'endroit où la branche sera insérée.

A l'étape suivante (ligne ≠0 et colonne ≠0), la structure branche est la branche sur laquelle se trouve la structure mère de l'étape précédente, qui devient alors la structure fille. On "redescend" lorsque les déplacements horizontal et vertical sont nuls ou lorsque le noeud divergent est atteint.

### A) Description d'une opération d'insertion d'un élément

Dans l'exemple de la figure 9, on a deux étapes qui sont les suivantes :

### 1ère étape :

La structure branche est la branche E3→Z0 et la structure mère est le noeud convergent E3.

### 2ème étape :

La structure branche est la branche A→B2 et la structure mère est le noeud divergent A. La structure fille est le noeud convergent E3.

A l'aller, à chaque étape, on calcule la valeur des déplacements à effectuer (déplacement horizontal et déplacement vertical) et les régions à déplacer et on modifie les tailles des structures branche et mère. Au retour, à chaque étape, on effectue les déplacements, puis on réalise l'insertion.

La valeur des déplacements initiaux et de la région en bas initiale dépend du type d'insertion.
1. Dans le cas de l'insertion d'une branche :
   . x-depl-initial=x-branche(branche à insérer)
   . y-depl-initial=y-branche(branche à insérer)
   . Région en bas initiale = région vide.
2. Dans le cas de l'insertion d'un noeud
   . x-depl-initial=Max(0,x-noeud(noeud à insérer)-x-branche(structure branche)
   . y-depl-initial=y-noeud(noeud à insérer)

   . Région en bas initiale
      ligne=ligne(noeud à insérer)
      colonne=colonne(structure branche)
      largeur=x-branche(structure branche)
      hauteur= Σ (y-noeud, noeud appartenant à la structure branche et suivant le noeud à insérer).

Dans les étapes suivantes, quel que soit le type d'insertion et de plus, à l'initialisation en ce qui concerne la région à droite, on a :
. y-depl=Max(0, y-branche(structure branche)-y-noeud(structure mère)+1)
. x-depl=Max(0,x-noeud(structure fille)-x-branche(structure branche))

. Région à droite
   ligne=ligne(structure mère)
   colonne=colonne(structure branche)+x-branche (structure branche)
   largeur=si il existe une branche à droite de la structure branche
   alors colonne(structure mère)+x-noeud(structure mère)-colonne(branche à droite)
   sinon 0 hauteur=y-noeud(structure mère).
. Région en bas
   ligne=ligne(structure fille)+y-noeud(structure fille)-y-depl
   colonne=colonne(structure branche)
   largeur=x-branche(structure branche)
   hauteur= Σ (y-noeud, noeud ε structure branche et noeud suivant la structure fille).

Le traitement des flèches consiste à modifier :
- la coordonnée colonne de toutes les branches à droite de la structure branche, s'il en existe :
- pour toute branche à droite bi : colonne(bi)=colonne(bi)+x-depl.
- la x-taille de la flèche horizontale de la branche immédiatement à droite de la structure branche.

En cas d'insertion d'une branche, et uniquement à la première étape :
x-taille(branche à droite)=x-taille(branche à insérer).
Dans tous les autres cas :
x-taille(branche à droite)=x-taille(branche à droite)+x-depl. Le traitement de liens : Ce cas concerne les noeuds convergents. L'analyse du noeud se fait à travers toutes ses branches (bi) et de droite à gauche. Les liens sont calculés à chaque étape.
branches bi (bi,i=l à n, l représentant la branche la plus à droite).
Trois cas différents peuvent être rencontrés :

La branche bi n'a pas de lien :

Le dernier noeud de la branche bi est un terminateur et il n'y a pas de lien à droite (toutes les branches bi finissent par un noeud terminateur).

Dans ce cas, aucune information n'est calculée.

La branche bi a un lien horizontal :

Le dernier noeud de la branche bi est un terminateur et il y a au moins un lien à droite (au moins une des branches à droite de bi ne se finit pas par un terminateur). Dans ce cas, il faut calculer les coordonnées de départ du lien et son étendue. y-taille (bi) dans un lien horizontal est toujours = 0.
colonne=colonne(bi)
ligne=ligne (structure mère)+y-noeud(structure mère)-1)
x-taille=x-branche(branche à gauche (bi+1))
s'il y a une branche à gauche sinon 0
y-taille=0

La branche bi a un lien vertical-horizontal :

Le dernier noeud de la branche bi n'est pas un terminateur. Dans ce cas, il faut calculer les coordonnées de départ du lien et son étendue.
colonne=colonne(bi)
ligne=ligne(bi)+y-branche(bi)
x-taille=x-branche(branche à gauche (bi+1))
s'il y a une branche à gauche sinon 0.
y-taille=y-noeud(structure mère)-y-branche (bi)-1

### B) Description plus détaillée des différentes étapes du procédé dans le cas d'une insertion.

1) Le procédé comporte tout d'abord une étape d'initialisation consistant à :
   a) déterminer la structure branche initiale et sa structure mère
   b) calculer les déplacements initiaux : déplacement horizontal (x-depl) et déplacement vertical(y-depl)
   c) calculer la région à droite initiale et la région en bas initiale.
2) Puis le procédé met en oeuvre les étapes itératives suivantes :
   a) Traitement des flèches
   b) Mise à jour de la structure branche
      x-branche(structure branche)=x-branche(structure branche+x-depl
      y-branche(structure branche)=y-branche(structure branche)+y-depl
   c) Calcul du nouveau déplacement vertical
      y-depl=Max(0, y-branche(structure branche) -y-noeud(structure mère)+1)
   d) Mise à jour de la structure mère
      x-noeud(structure mère)=x-noeud(structure mère)+x-depl
      y-noeud(structure mère)=y-noeud(structure mère)+y-depl
   e) Traitement des liens
   f) Si la structure mère est le noeud divergent ou
      si les déplacements sont tous les deux nuls
      alors déplacement horizontal des régions à droite et déplacement vertical des régions en bas de la dernière structure mère à la première (c'est-à-dire celle qui contient la structure à insérer) puis insertion de la structure
      sinon
      . calcul de la nouvelle structure branche
      . calcul de la structure fille
      . calcul de la nouvelle structure mère
      . nouveau déplacement horizontal
         x-depl=Max(0,x-noeud(structure fille)-x-branche(structure branche))
      . Calcul de la nouvelle région à droite
      . Calcul de la nouvelle région en bas
      . Retour en 2a)

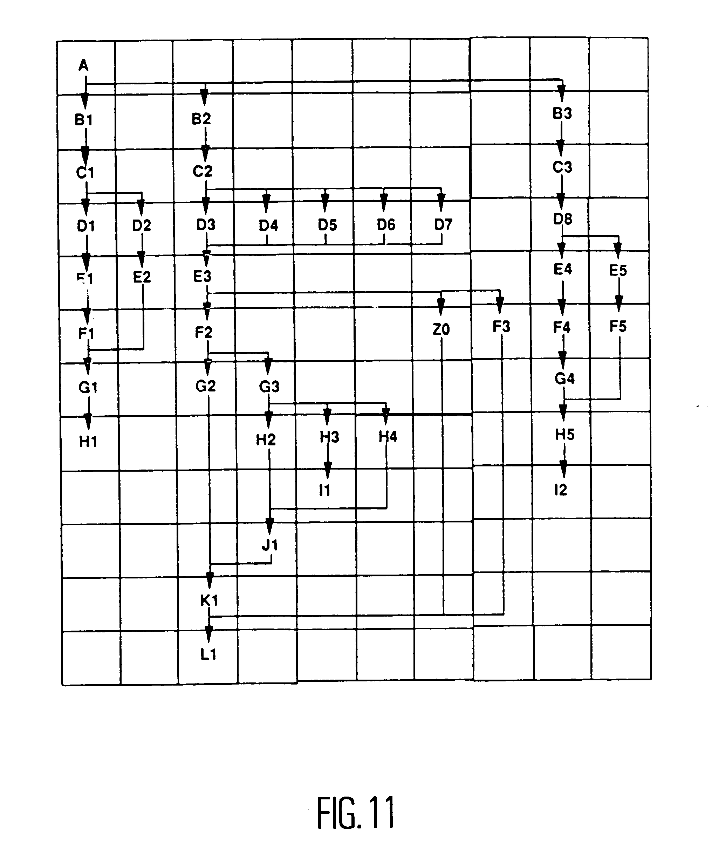

### a) Cas de l'insertion d'une branche (figures 9, 10 et 11)

### Initialisation

. structure branche=branche vide positionnée à ligne=5 et colonne=7, (x-branche=0, y-branche=0)
. structure mère=noeud convergent E3
. x-depl=x-branche (E3→ZO)=1
. y-depl=y-branche (E3→ZO)=1
. Région à droite initiale
   ligne=ligne (E3)=5
   colonne=colonne(structure branche)=7
   largeur=colonne (E3)+x-noeud(E3)-colonne(E3→ F3) = 3+5-7=1
   hauteur=y-noeud (E3)=7
. Région en bas initiale=Région vide

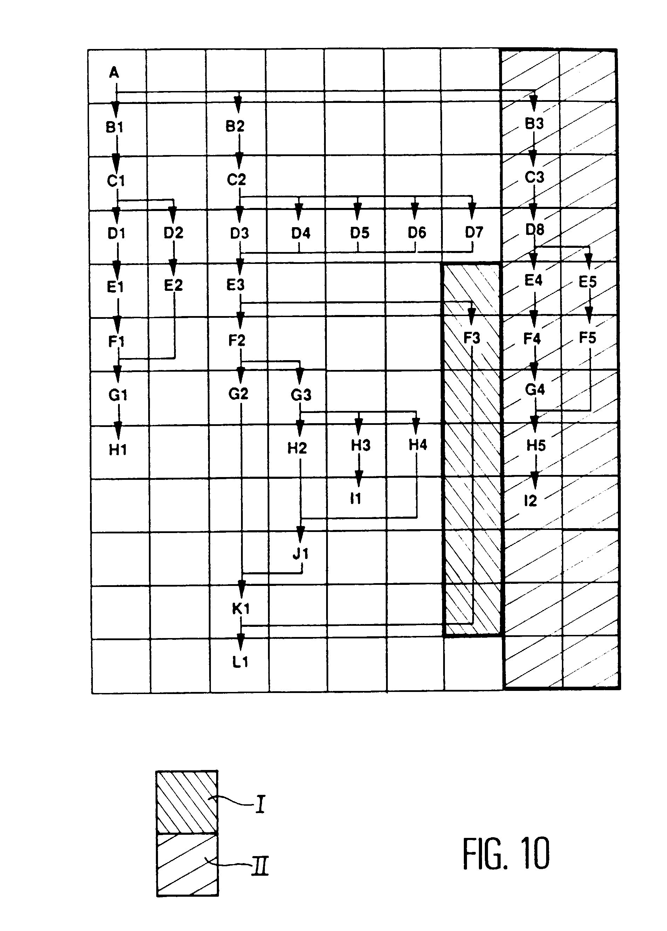

### Etape 1 (région I , figure 10)

. Traitement des flèches
   colonne (E3→F3)=7+1=8
   x-taille (E3→F3)=1
. Mise à jour de la structure branche
   x-branche=0+1=1
   y-branche=0+1=1
. Nouveau déplacement vertical
   y-depl=Max(0,y-branche(E3→ZO)-y-noeud(E3)+1 = Max(0,1-7+1)=0
. Mise à jour de la structure mère
   x-noeud (E3)=5+1=6
   y-noeud (E3)=7+0=7
. Traitement des liens
. Branche (E3→F3).(b1). Lien vertical horizontal
   colonne=colonne (E3→F3)=8
   ligne=ligne (b1)+y-branche(b1)=5+1=6
   x-taille=x-branche(E3→ZO)=1
   y-taille=y-noeud(E3)-y-branche(E3→F3)-1=7-1-1=5
. Branche (E3→ZO).(b2). Lien vertical horizontal
   colonne=colonne (E3→ZO)=7
   ligne=ligne (b2)+y-branche (b2)=5+1=6
   x-taille=x-branche (E3→F2)=4
   y-taille=y-noeud (E3)-y-branche(E3→ZO)-1 =7-1-1=5
. Branche (E3→F2).(b3). Lien vertical horizontal
   colonne=colonne (E3→F2)=3
   ligne=ligne (b3)+ y-branche (b3)=5+6=11
   x-taille=0
   y-taille=y-noeud (E3)-y-branche(b3)-1=7-6-1=0
. Nouvelle structure branche=branche (A→B2)
. Nouvelle structure mère=noeud divergent (A)
. Structure fille=noeud convergent (E3)
. Nouveau déplacement horizontal
   x-depl=Max(0,x-noeud(E3)-x-branche(A→B2))= Max(0,6-5)=1
. Nouvelle région à droite
   ligne=ligne (A)
   colonne=colonne (A→B2)+x-branche (A→B2) = 3+5=8
   largeur=colonne (A) + x-noeud(A)-colonne (A→B3)=1+9-8=2
   hauteur=y-noeud(A)=12
. Nouvelle région en bas (ne se calcule pas car y-depl=0)

### Etape 2 (région II, figure 10)

. Traitement des flèches
   colonne (A→B3)=colonne (A→B3)+1 = 8+1=9
   x-taille(A→B3)=x-taille (A→B3)+1=5+1=6
. Mise à jour de la structure branche
   x-branche(A→B2)=5+1=6
   y-branche(A→B2)=11+0=11
. Nouveau déplacement vertical
   y-depl=Max(0,y-branche(A→B2)-y-noeud(A) +1)=0
. Mise à jour de la structure mère
   x-branche(A)=9+1=10
   y-branche(A)=12+0=12
. Traitement des liens : Néant car la structure mère est le noeud divergent.
. La structure mère étant le noeud divergent, déplacement des régions II, puis I respectivement selon les déplacements calculés aux étapes II, puis I et insertion de la branche E3→ZO.

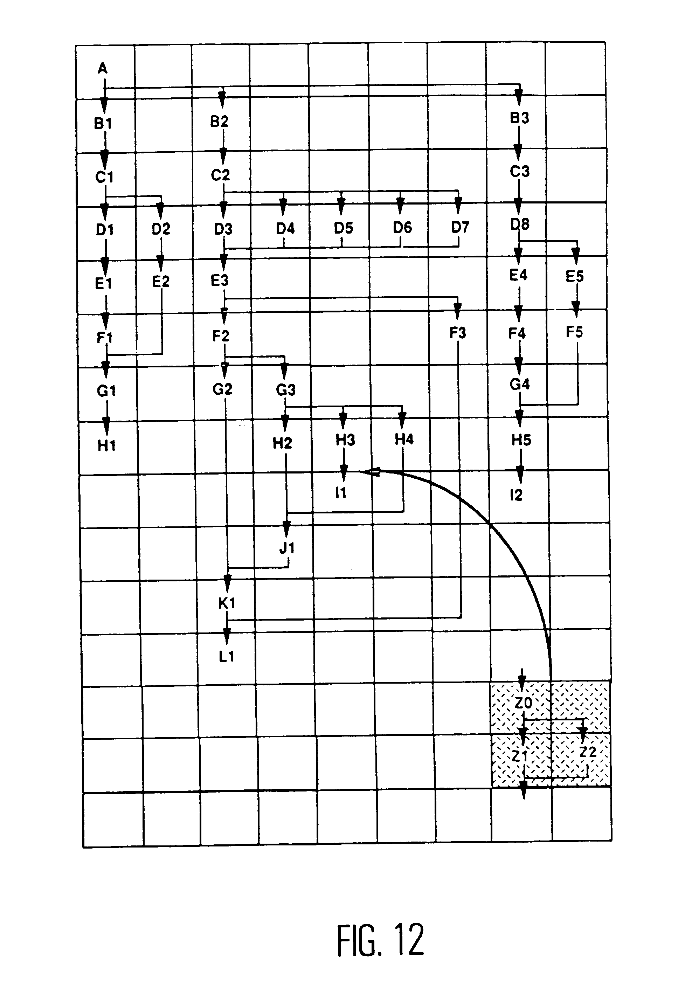

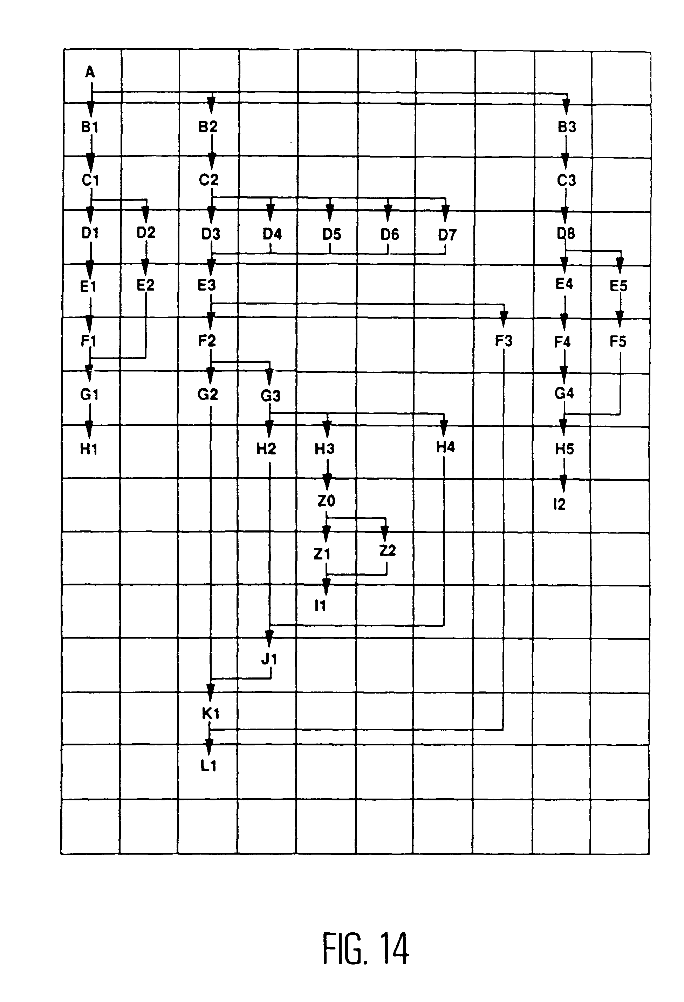

### b) Cas de l'insertion d'un noeud (figures 12, 13 et 14)

### Initialisation

. structure branche=branche(G3→H3)
. Structure mère=noeud convergent (G3)
   x-depl= Max(0,x-noeud (ZO)-x-branche(G3→H3)) = Max(0,2-1)=1
. y-depl=y-noeud(Z0)=2
. Région à droite initiale
   ligne=ligne(G3)=7
   colonne=colonne(G3→H3)+x-branche(G3→H3) = 5+1=6
   largeur=colonne(G3)+x-noeud(G3)-colonne(G3→H4) = 4+3-6=1
   hauteur=y-noeud(G3)=3
. Région en bas initiale
   ligne=ligne(Z0)=9
   colonne=colonne(G3→H3)=5
   largeur=x-branche(G3→H3)=1
   hauteur=y-noeud(I1)=1

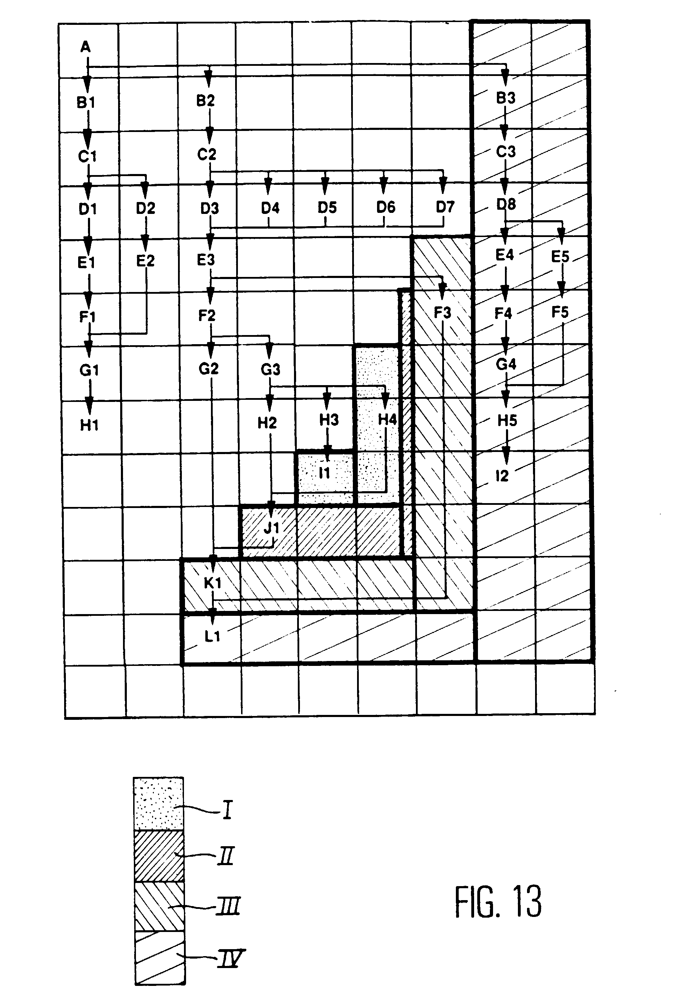

### Etape 1 (région I , figure 13)

. Traitement des flèches
   colonne(G3→H4)=6+1=7
   x-taille(G3→H4)=x-taille(G3→H4)+x-depl =1+1=2
. Mise à jour de la structure branche
   x-branche(G3→H3)=1+1=2
   y-branche(G3→H3)=2+2=4
      . Nouveau déplacement vertical
   y-depl=Max(0,y-branche(G3→H3)-y-noeud(G3) +1) = Max(0,4-3+1)=2
. Mise à jour de la structure mère
   x-noeud(G3)=3+1=4
   y-noeud(G3)=3+2=5
. Traitement des liens
. Branche(G3→H4).(b1). Lien vertical-horizontal
   colonne=colonne(b1)=7
   ligne=ligne(b1)+y-branche(b1)=7+1=8
   x-taille(G3→H4)=x-branche(G3→H3)=2
   y-taille(G3→H4)=y-noeud(G3)-y-branche (b1)-1=5-1-1=3
. Branche (G3→H3)-(b2). Lien vertical horizontal
   colonne=colonne(b2)=5
   ligne=ligne(b2)+y-branche(b2)=7+4=11
   x-taille(G3→H3)=x-branche(G3→H2)=1
   y-taille(G3→H3)=y-noeud(G3)-y-branche(b2):1 =5-4-1=0
. Branche(G3→H2).(b3). Lien vertical horizontal
   colonne=colonne (b3)=4
   ligne=ligne(b3)+y-branche(b3)=7+1=8
   x-taille(G3→H2)=0 (pas de branche à gauche)
   y-taille (G3→H3)=y-noeud(G3)-y-branche (b3)-1=5-1-1=3
. Nouvelle structure branche=branche(F2→G3)
. Nouvelle structure mère=noeud convergent F2
. Structure fille=noeud convergent G3
. Nouveau déplacement horizontal
   x-depl=Max(0,x-noeud(G3)-x-branche(F2→G3)) = Max(0, 4-3)=1
. Nouvelle région à droite
   ligne=ligne(F2)=6
   colonne=colonne (F2→G3)+x-branche(F2→G3) =4+3=7
   largeur=0 (pas de branche à droite)
   hauteur=y-noeud(F2)=5
. Nouvelle région en bas
   ligne=ligne(G3)+y-noeud(G3)-2=7+5-2=10
   colonne=colonne(F2→G3)=4
   largeur=x-branche(F2→G3)=3
   hauteur=y-noeud(J1)=1

### Etape 2 (région II , figure 13)

. Traitement des flèches
   pas de branche à droite
. Mise à jour de la structure branche
   x-branche(F2→G3)=3+1=4
   y-branche(F2→G3)=4+2=6
. Nouveau déplacement vertical
   y-depl=Max(0,y-branche(F2→G3)-y-noeud (F2)+1)
   =Max(0,6-5+1)=2
. Mise à jour de la structure mère
   x-noeud(F2)=4+1=5
   y-noeud(F2)=5+2=7
. Traitement des liens
   . Branche (F2→G3).(b1). Lien vertical-horizontal
      colonne=colonne(b1)=4
      ligne=ligne(b1)+y-branche(b1)=6+6=12
      x-taille(F2→G3)=x-branche(F2→G2)=1
      y-taille(F2→G3)=y-noeud(F2)-y-branche(b1)-1 = 7-6-1=0
   . Branche(F2→G2)-(b2). Lien vertical-horizontal
      colonne=colonne(b2)=3
      ligne=ligne(b2)+y-branche(b2)=6+1=7
      x-taille(F2→G2)=0 (pas de branche à gauche)
      y-taille (F2→G2)=y-noeud(F2)-y-branche (b2)-1=7-1-1=5
   . Nouvelle structure branche=branche (E3→F2)
   . Nouvelle structure fille=noeud convergent (F2)
   . Nouvelle structure mère=noeud convergent (E3)
   . Nouveau déplacement horizontal
      x-depl= Max(0,x-noeud(F2)-x-branche(E3→F2)) = Max(0,5-4)=1
         . Nouvelle région à droite
            ligne=ligne(E3)=5
            colonne=colonne (E3→F2)+x-branche(E3→F2)=3+4=7
            largeur=colonne(E3)+x-noeud(E3)-colonne (E3→F3) = 3+5-7=1
            hauteur=y-noeud(E3)=7
      . Nouvelle région en bas
         ligne=ligne (F2)+y-noeud(F2)-2 = 6+7-2=11
         colonne=colonne(E3→F2)=3
         largeur=x-branche(E3→F2)=4
         hauteur=y-noeud(K1)=1

### Etape 3 (région III,figure 13)

. Traitement des flèches
   colonne (E3→F3)=colonne (E3→F3)+1=7+1=8
   x-taille(E3→F3)=x-taille(E3→F3)+x-depl = 4+1=5
. Mise à jour de la structure branche
   x-branche(E3→F2)=4+1=5
   y-branche(E3→F2)=6+2=8
. Nouveau déplacement vertical
   y-depl=Max(O,y-branche(E3→F2)-y-noeud(E3) +1)=Max(0,8-7+1)=2
. Mise à jour de la structure mère
   x-noeud(E3)=5+1=6
   y-noeud(E3)=7+2=9
. Traitement des liens
   . Branche (E3→F3).(b1).Lien vertical-horizontal
      colonne=colonne(b1)=8
      ligne=ligne(b1)+y-branche(b1)=5+1=6
      x-taille(E3→F3)=x-branche(E3→F2)=5
      y-taille(E3→F3)=y-noeud(E3)-y-branche (b1)-1=9-1-1=7
   . Branche(E3→F2).(b2).Lien vertical-horizontal
      colonne=colonne(b2)=3
      ligne=ligne(b2)+y-branche(b2)=5+8=13
      x-taille(E3→F2)=0 (pas de branche à gauche)
      y-taille(E3→F2)-y-noeud(E3)-y-branche(b2)-1 = 9-8-1=0
. Nouvelle structure branche=branche(A→B2)
. Nouvelle structure mère=noeud divergent(A)
. Nouvelle structure fille=noeud convergent(E3)
. Nouveau déplacement horizontal
   x-depl=Max(0,x-noeud(E3)-x-branche(A→B2)) =Max(0,6-5)=1
. Nouvelle région à droite
   ligne=ligne(A)=1 colonne=colonne(A→B2)+x-branche(A→ B2) =3+5=8
   largeur=colonne(A)+x-noeud(A)-colonne(A→B3) =1+9-8=2
   hauteur=y-noeud(A)=12
. Nouvelle région en bas
   ligne=ligne(E3)+y-noeud(E3)-2=5+9-2=12 colonne=colonne(A→B2)=3
   largeur=x-branche(A→B2)=5
   hauteur=y-noeud(L1)=1

### Etape 4 (région IV, figure 13)

. Traitement des flèches
   colonne(A→B3)=colonne(A→B3)+1=8+1=9 x-taille(A→B3)=x-taille(A→B3)+x-depl= 5+1=6
. Mise à jour de la structure branche
   x-branche(A→B2)=5+1=6
   y-branche(A→B2)=11+2=13
. Nouveau déplacement vertical
   y-depl=Max(0,y-branche(A→B2)-y-noeud(A)+1) =Max(0,13-12+1)=2
. Mise à jour de la structure mère
   x-noeud(A)=9+1=10
   y-noeud(A)=12+2=14
. Traitement des liens : Néant car la structure mère est le noeud divergent.
. Arrêt de l'analyse. Déplacement des régions IV, puis III, puis II, puis I respectivement selon les déplacements calculés aux étapes IV, puis III, puis II, puis I et insertion du noeud ZO.

## Revendications

1. Procédé de décompilation pour la réalisation de graphes au moyen d'un ordinateur relié à un écran de visualisation caractérisé en ce qu'il comporte les étapes suivantes :
- définir et enregistrer en mémoire une structure de donnée décrivant tout graphe à toutes les étapes de sa création sous la forme d'une structure arborescente comportant un noeud divergent correspondant à la racine de l'arbre relié à des noeuds simples,convergents ou terminateurs, les noeuds autres que les noeuds terminateurs étant reliés à d'autres noeuds simples, convergents ou terminateurs, de sorte que les différents noeuds sont la base de structures s'englobant les unes dans les autres ;
- établir une table de correspondance entre la représentation interne arborescente décrite dans la structure de donnée et sa représentation graphique externe sur l'écran dans laquelle chaque élément du graphe est repéré par rapport à des zones de l'écran résultant d'un découpage matriciel en lignes et colonnes ;
- procéder à la réalisation effective du graphe en effectuant des opérations d'insertion et/ou de destruction successives d'éléments définis dans la structure de donnée, ces insertions et/ou destructions se faisant dans les zones désirées de l'écran par des opérations successives de décalages des éléments du graphe situés au-delà des zones dans lesquelles se trouve l'élément à insérer ou à détruire.
- afficher le graphe au fur et à mesure de sa construction et de ses modifications,
- mettre à jour la description interne et la table de correspondance.

2. Procédé selon la revendication 1, caractérisé en ce qu'une opération de destruction comporte les étapes itératives suivantes :
- déterminer la structure englobante de l'élément à détruire ;
- déterminer les décalages à effectuer successivement de la droite vers la gauche pour les éléments de structures englobantes en structures englobantes jusqu'à ce que ces décalages soient nuls ou jusqu'à ce que le noeud divergent soit atteint ;
- déterminer des décalages à effectuer successivement de bas en haut pour les éléments de structures englobantes en structures englobantes jusqu'à ce que ces décalages soient nuls ou jusqu'à ce que le noeud divergent soit atteint.

3. Procédé selon la revendication 2, caractérisé en ce que la détermination de la structure englobante consiste à :
- déterminer la structure branche de l'élément à détruire ;
- déterminer la structure mère de cet élément.

4. Procédé selon l'une quelconque des revendications précédentes, caractérisé en ce que la détermination des décalages à effectuer de la droite vers la gauche et de bas en haut consiste à :
- déterminer une région à droite de l'élément et une région en bas par les coordonnées de ces régions, la largeur et la hauteur ;
- déterminer la valeur des déplacements à effectuer x-depl et y-depl correspondants.

5. Procédé selon la revendication 1, caractérisé en ce qu'une opération d'insertion comporte les étapes itératives suivantes :
- déterminer la structure englobante de plus haut niveau ;
- déterminer les décalages à effectuer successivement de la gauche vers la droite pour les éléments de structures englobantes en structures englobantes, depuis la structure englobante de plus haut niveau jusqu'à la structure qui contient l'élément à insérer ;
- déterminer les décalages à effectuer successivement de haut en bas pour les éléments de structures englobantes en structures englobantes.

6. Procédé selon la revendication 5, caractérisé en ce que la détermination de la structure englobante consiste à :
- déterminer la structure branche qui contient l'élément à insérer,
- déterminer la structure mère de cet élément.

7. Procédé selon l'une quelconque des revendications 5 ou 6, caractérisé en ce que la détermination des décalages à effectuer de la droite vers la gauche ou de haut en bas consiste à :
- déterminer une région à droite de l'élément et une région en bas par les coordonnées de ces régions, la largeur et la hauteur,
- déterminer la valeur des déplacements à effectuer x-depl et y-depl correspondants.

## Patentansprüche

1. Dekompilationsverfahren zur Erstellung eines Graphs mit Hilfe eines an einen Bildschirm angeschlossenen Computers, dadurch gekennzeichnet, daß dieses Verfahren folgende Abschnitte umfaßt:
- Definition und Speicherung einer Datenstruktur, die den gesamten Graph in allen Erstellungsabschnitten in Form einer Baumstruktur beschreibt, die in bezug auf ihre Wurzel einen auseinanderlaufenden Knoten enthält, der mit einfachen zusammenlaufenden Knoten bzw. Endknoten verbundenen ist, wobei die Knoten, die keine Endknoten darstellen, mit weiteren zusammenlaufenden Knoten bzw. Endknoten verbunden sind, so daß diese verschiedenen Knoten die Grundlage von Strukturen bilden, die sich gegenseitig umfassen;
- Erstellung einer Zuordnungstabelle zwischen der durch die Datenstruktur beschriebenen internen Baumstrukturdarstellung und der entsprechenden externen graphischen Darstellung auf dem Bildschirm, in der jedes Element des Graphs in bezug auf die Bildschirmabschnitte markiert ist, die sich aus einer Matrixunterteilung in Zeilen und Spalten ergeben;
- Verfahren zur effektiven Erstellung des Graphs durch sukzessives Einfügen bzw. Löschen von in der Datenstruktur festgelegten Elementen, wobei diese Einfügungs- bzw. Löschoperationen in den gewünschten Abschnitten des Bildschirmes durch aufeinanderfolgende Verschiebungen der Elemente des Graphs erfolgen, die sich außerhalb der Abschnitte befinden, in denen sich ein einzufügendes oder zu löschendes Element befindet.
- Anzeige des Graphen in Abhängigkeit seines Aufbaus und den entsprechenden Änderungen,
- Aktualisierung der internen Beschreibung und der Zuordnungstabelle.

2. Verfahren nach Anspruch 1, dadurch gekennzeichnet, daß eine Löschoperation die folgenden, sich wiederholenden Abschnitte umfaßt:
- Bestimmung der Struktur, die das zu löschende Element beinhaltet;
- Bestimmung der Verschiebungen, die nacheinander von links nach rechts für die Elemente der Strukturen durchzuführen sind, welche in den umfassenden Strukturen enthalten sind, bis diese Verschiebungen den Wert Null haben oder bis der auseinanderlaufende Knoten erreicht ist;
- Bestimmung der Verschiebungen, die nacheinander von unten nach oben für die Elemente der Strukturen durchzuführen sind, welche in den umfassenden Strukturen enthalten sind, bis diese Verschiebungen den Wert Null haben oder bis der auseinanderlaufende Knoten erreicht ist.

3. Verfahren nach Anspruch 2, dadurch gekennzeichnet, daß die Bestimmung der umfassenden Struktur aus folgenden Operationen besteht:
- Bestimmung der Unterstruktur des zu löschenden Elementes;
- Bestimmung der Stammstruktur dieses Elementes.

4. Verfahren nach einem beliebigen der vorangegangenen Ansprüche, dadurch gekennzeichnet, daß die Bestimmung der von links nach rechts sowie von unten nach oben auszuführenden Verschiebungen aus folgenden Operationen besteht:
- Bestimmung eines Abschnittes rechts von dem Element und eines Abschnittes darunter durch die Koordinaten dieser Abschnitte, d.h. die Breite und die Höhe;
- Bestimmung des Wertes der in die entsprechenden x- und y-Richtungen vorzunehmenden Verschiebungen.

5. Verfahren nach Anspruch 1, dadurch gekennzeichnet, daß eine Einfügungsoperation die folgenden, sich wiederholenden Abschnitte umfaßt;
- Bestimmung der umfassenden Struktur der höheren Ebene;
- Bestimmung der Verschiebungen, die nacheinander von links nach rechts für die Elemente der Strukturen durchzuführen sind, welche in den umfassenden Strukturen enthalten sind, danach der umfassenden Struktur der höheren Ebene bis zu der Struktur, die das einzufügende Element enthält;
- Bestimmung der Verschiebungen, die nacheinander von unten nach oben für die Elemente der Strukturen durchzuführen sind, welche in den umfassenden Strukturen enthalten sind.

6. Verfahren nach Anspruch 5, dadurch gekennzeichnet, daß die Bestimmung der umfassenden Struktur aus folgenden Operationen besteht:
- Bestimmung der Unterstruktur, die das einzufügende Element enthält,
- Bestimmung der Stammstruktur dieses Elementes.

7. Verfahren nach einem beliebigen der Ansprüche 5 oder 6, dadurch gekennzeichnet, daß die Bestimmung der von rechts nach links bzw. von oben nach unten auszuführenden Bestimmungen aus folgenden Operationen besteht:
- Bestimmung eines Abschnittes rechts von dem Element und eines Abschnittes darunter durch die Koordinaten dieser Abschnitte, d.h. die Breite und die Höhe;
- Bestimmung des Wertes der in die entsprechenden x- und y-Richtungen vorzunehmenden Verschiebungen.

## Claims

1. Decompilation process for producing graphs by means of a computer connected to a display screen, characterized in that it comprises the following stages:
defining and storing in a memory a data structure describing any graph at all stages of its creation in the form of a tree structure having a divergent node corresponding to the root of the tree connected to simple, convergent or terminator nodes, the nodes other than the terminator nodes being connected to other simple, convergent or terminator nodes, so that the different nodes form the basis for structures interleaved in one another;
drawing up a table of correspondence between the internal, tree-like representation described in the data structure and its external graphic representation on the screen, in which each element of the graph is marked relative to areas of the screen resulting from a matrix subdivision into rows and columns;
effectively producing the graph by carrying out successive insertion and/or destruction operations of elements defined in the data structure, said insertions and/or destructions taking place in the desired areas of the screen by successive operations of shifting graph elements located beyond the areas in which is located the element to be inserted or destroyed:
displaying the graph during its production and its modifications; updating the internal description and the table of correspondence.

2. Process according to claim 1, characterized in that a destruction operation comprises the following iterative stages:
determining the covering structure of the element to be destroyed,
determining the shifts to be successively carried out from right to left for elements between individual covering structures until these shifts are zero or until the divergent node is reached,
determining the shifts to be successively carried out from bottom to top for the elements of the individual covering structures until the shifts are zero or until the divergent node is reached.

3. Process according to any one of the preceding claims, characterized in that the determination of the covering structure comprises:
determining the branch structure of the element to be destroyed,
determining the mother structure of said element.

4. Process according to any one of the preceding claims, characterized in that the determination of the shifts to be carried out from right to left and bottom to top consists of:
determining a right region of the element and a bottom region by the coordinates of these regions, the width and the height,
determining the value of the corresponding displacements to be made x-displ and y-displ.

5. Process according to claim 1, characterized in that the insertion operation comprises the following iterative stages:
determining the covering structure of the highest level,
determining the shifts to be successively made from left to right for the elements of the individual covering structures from the highest level covering structure to the structure containing the element to be inserted,
determining the shifts to be successively carried out from top to bottom for the individual covering structures.

6. Process according to claim 5, characterized in that the determination of the covering structure consists of:
determining the branch structure containing the element to be inserted,
determining the mother structure of said element.

7. Process according to either of the claims 5 or 6, characterized in that the determination of the shifts to be carried out from right to left or top to bottom consists of:
determining a right region of the element and a bottom region by the coordinates of said regions, the width and the height,
determining the value of the corresponding displacements to be carried out x-displ and y-displ.
